**Europäisches Patentamt**

**European Patent Office**

**Office européen des brevets**

(19)

(11) **EP 1 202 101 A2**

(12) **EUROPÄISCHE PATENTANMELDUNG**

(43) Veröffentlichungstag:
02.05.2002 Patentblatt 2002/18

(51) Int Cl.$^7$: **G02B 19/00**, G03F 7/20

(21) Anmeldenummer: 01123629.6

(22) Anmeldetag: 02.10.2001

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **27.10.2000 DE 10053587**

(71) Anmelder: **Carl Zeiss**
**89518 Heidenheim (Brenz) (DE)**

(72) Erfinder: **Singer, Wolfgang, Dr.**
**73431 Aalen (DE)**

(74) Vertreter: **Sawodny, Michael-Wolfgang**
**Dr. Weitzel & Partner,**
**Friedenstrasse 10**
**89522 Heidenheim (DE)**

(54) **Beleuchtungssystem mit variabler Einstellung der Ausleuchtung**

(57) Die Erfindung betrifft ein Beleuchtungssystem für Wellenlängen ≤ 193 nm, insbesondere für die EUV-Lithographie, mit

- einer Lichtquelle
- einer Objektebene
- einer Austrittspupille
- einem ersten optischen Element mit Rasterelementen, das durch die Lichtquelle ausgeleuchtet wird und daß das von der Lichtquelle her einfallende Lichtbündel in Lichtkanäle zerlegt
- einem zweiten optischen Element mit Rasterelementen, wobei jedem Lichtkanal, der von dem Rasterelement des ersten optischen Elementes ausgebildet wird, ein Rasterelement des zweiten optischen Elementes zugeordnet ist,
  wobei
- die Rasterelemente des ersten optischen Elementes und des zweiten optischen Elementes jeweils Lichtkanälen zugeordnet sind, und die Rasterelemente derart ausgestaltet oder angeordnet werden, daß sich für jeden Lichtkanal ein durchgehender Strahlverlauf von der Lichtquelle bis zur Objektebene ergibt

  dadurch gekennzeichnet, daß

- die Zuordnung derart manipulierbar ist, daß durch die Zuordnung der Rasterelemente des ersten und des zweiten optischen Elementes eine vorgegebene Ausleuchtung in der Austrittspupille des Beleuchtungssystems eingestellt wird.

Printed by Jouve, 75001 PARIS (FR)

**Beschreibung**

Die Erfindung betrifft ein Beleuchtungsssytem gemäß dem Oberbegriff des Anspruches 1, ein Verfahren zur Einstellung der Ausleuchtung in der Austrittspupille eines Beleuchtungssystems sowie eine Projektionsbelichtungsanlage mit einem derartigen Beleuchtungssystem.

Um die Strukturbreiten für elektronische Bauteile noch weiter reduzieren zu können, insbesondere in den Submikron-Bereich, ist es erforderlich, die Wellenlänge des für die Mikrolithographie eingesetzten Lichtes zu verringern. Denkbar ist bei Wellenlängen kleiner als 193 nm beispielsweise die Lithographie mit weichen Röntgenstrahlen, sog. EUV-Lithographie.

Ein für die EUV-Lithographie geeignetes Beleuchtungssystem soll mit möglichst wenigen Reflektionen das für die EUV-Lithographie vorgegebene Feld, insbesondere das Ringfeld eines Objektivs homogen, d.h. uniform ausleuchten, des weiteren soll die Pupille des Objektives feldunabhängig bis zu einem bestimmten Füllgrad σ ausgeleuchtet werden und die Austrittspupille des Beleuchtungssystems in der Eintrittspupille des Objektivs liegen.

Aus der US 5,339,346 ist ein Beleuchtungssystem für eine Lithographieeinrichtung, die EUV-Strahlen verwendet, bekanntgeworden. Zur gleichmäßigen Beleuchtung in der Retikelebene und Füllung der Pupille schlägt die US 5,339,346 einen Kondensor vor, der als Kollektorlinse aufgebaut ist und wenigstens vier paarweise Spiegelfacetten, die symmetrisch angeordnet sind, umfaßt. Als Lichtquelle wird eine Plasma-Lichtquelle verwendet.

In der US 5,737,137 ist ein Beleuchtungssystem mit einer Plasma-Lichtquelle umfassend einen Kondensorspiegel, gezeigt, bei dem mit Hilfe von sphärischen Spiegeln eine Ausleuchtung einer zu beleuchtenden Maske bzw. eines Retikels erzielt wird.

Die US 5,361,292 zeigt ein Beleuchtungssystem, bei dem eine Plasma-Lichtquelle vorgesehen ist und die punktförmige Plasma-Lichtquelle mit Hilfe eines Kondensors, der fünf asphärische, außermittig angeordnete Spiegel aufweist, in eine ringförmig ausgeleuchtete Fläche abgebildet wird. Mit Hilfe einer speziellen nachgeordneten Abfolge von grazing-incidence-Spiegeln wird die ringförmig ausgeleuchtete Fläche dann in die Eintrittspupille abgebildet.

Aus der US 5,581,605 ist ein Beleuchtungssystem bekanntgeworden, bei dem ein Photonenstrahler mit Hilfe eines Wabenkondensors in eine Vielzahl von sekundären Lichtquellen aufgespalten wird. Hierdurch wird eine gleichmäßige bzw. uniforme Ausleuchtung in der Retikelebene erreicht. Die Abbildung des Retikels auf den zu belichtenden Wafer erfolgt mit Hilfe einer herkömmlichen Reduktionsoptik. Im Beleuchtungsstrahlengang ist genau ein gerasterter Spiegel mit gleich gekrümmten Elementen vorgesehen.

Die EP 0 939 341 zeigt ein Köhler sches Beleuchtungssystem für Wellenlängen < 200 nm, insbesondere auch für den EUV-Bereich, mit einem ersten optischen Integrator umfassend eine Vielzahl von ersten Rasterelementen und einem zweiten optischen Integrator, umfassend eine Vielzahl von zweiten Rasterelementen. Die Steuerung der Beleuchtungsverteilung in der Austrittspupille erfolgt über ein Blendenrad, was mit einem erheblichen Lichtverlust verbunden ist. Alternativ hierzu wird für eine Quadrupol-Beleuchtungsverteilung das Aufspalten des Lichtstrahles nach der Quelle und vor dem ersten optischen Integrator in vier Lichtstrahlen vorgeschlagen. Auch unterschiedliche anwendbare Ausleuchtungen können gemäß der EP 0 939 341 ohne Einsatz von Blenden beispielsweise durch Wechseloptiken realisiert werden. Diese Art der Änderung der Ausleuchtung ist zum einen sehr aufwendig, zum anderen auf bestimmte Arten der Ausleuchtung, nämlich annular und quadrupolar beschränkt.

Aus der DE 199 03 807 A1 ist ein weiteres EUV-Beleuchtungssystem bekanntgeworden, das zwei Spiegel oder Linsen mit Rasterelementen umfaßt. Derartige Systeme werden auch als doppel facettierte EUV-Beleuchtungssysteme bezeichnet. Der Offenbarungsgehalt dieser Anmeldung wird in die vorliegende Anmeldung vollumfänglich mit aufgenommen.

In der DE 199 03 807 A1 ist der prinzipielle Aufbau eines doppelt facettierten EUV-Beleuchtungssystems, gezeigt. Die Ausleuchtung in der Austrittspupille des Beleuchtungssystems gemäß der DE 199 03 807 wird durch die Anordnung der Rasterelemente auf dem zweiten Spiegel bestimmt. Eine variable Steuerung der Ausleuchtung in der Austrittspupille bzw. die Einstellung einer vorbestimmten Beleuchtungsverteilung ist gemäß der DE 199 03 807 durch einfache Maßnahmen nicht beschrieben.

Aufgabe der Erfindung ist es, ein möglichst einfach aufgebautes doppelt facettiertes Beleuchtungssystem, das eine variable Einstellung einer beliebigen Beleuchtungsverteilung in der Austrittspupille weitgehend ohne Lichtverluste zuläßt sowie ein Verfahren zum Einstellen einer Beleuchtungsverteilung bei einem derartigen Beleuchtungssystem anzugeben.

Erfindungsgemäß wird die Aufgabe dadurch gelöst, daß bei dem oberbegrifflichen Beleuchtungssystem, wie es beispielsweise aus der DE 199 03 807 A1 bekannt geworden ist, durch Änderung der Auftreffpunkte der von der Lichtquelle zur Austrittspupille durchgehenden Lichtkanäle eine vorgegebene Ausleuchtung in der Austrittspupille eingestellt wird. Durch eine derartige Einstellung der Lichtverteilung in der Austrittspupille können beliebige Verteilungen realisiert werden und Lichtverluste, wie sie beispielsweise bei Lösungen mit Blenden auftreten, werden vermieden.

Während das System bei Wellenlängen im EUV-Bereich rein reflektiv, d.h. ausschließlich mit Spiegelkomponenten entworfen ist, gelangen bei 193 nm bzw. 157 nm-System refraktive Komponenten wie Linsen bzw. Linsenarrays als sogenannte optische Integratoren zum Einsatz.

Die Erfindung stellt somit auch im 193 nm bzw. 157 nm-Bereich ein Beleuchtungssystem zur Verfügung, mit dem die Ausleuchtung der Austrittspupille auf einfache Art und Weise eingestellt und verändert werden kann.

Mit dem erfindungsgemäßen Beleuchtungssystem wird das Feld in der Retikelebene homogen und mit partiell gefüllter Apertur sowie die Austrittspupille des Beleuchtungssystems variabel ausgeleuchtet.

Nachfolgend sollen einige Lichtverteilungen in der Austrittspupille, wie sie mit Hilfe der Erfindung erhalten werden können, beschrieben werden.

Bei kreisförmiger Ausleuchtung wird die Lichtverteilung bzw. das Beleuchtungssetting in der Austrittspupille, die vorliegend mit der Objektivpupille zusammenfällt, durch den Füllfaktor σ definiert. Es gilt:

$$\text{Füllfaktor: } \sigma = \frac{r_{Beleuchtung}}{R_{Objektivapertur}}$$

Dabei bezeichnet $r_{Beleuchtung}$ den Radius der Ausleuchtung und $R_{Objektivapertur}$ den Radius der Objektivapertur.

Definitionsgemäß ist für σ = 1,0 die Objektivpupille vollständig gefüllt; und beispielsweise σ = 0,6 entspricht einer Unterfüllung.

Bei einer annularen Lichtverteilung ist die Objektivpupille ringförmig ausgeleuchtet. Zu ihrer Beschreibung kann man folgende Definition von $\sigma_{out}/\sigma_{in}$ verwendet:

$$\sigma_{out} = \frac{r(90)}{R(NA_{max})} \quad wobei \quad \int_{0}^{r(90)} I(r)\,r\,dr = 0,9 \cdot \int_{0}^{R(NA_{max})} I(r)\,r\,dr$$

$$\sigma_{in} = \frac{r(10)}{R(NA_{max})} \quad wobei \quad \int_{0}^{r(10)} I(r)\,r\,dr = 0,1 \cdot \int_{0}^{R(NA_{max})} I(r)\,r\,dr$$

Eine weitere Lichtverteilung ist die sogenannte Quadrupol-Beleuchtung zur Abbildung von beispielsweise "Manhatten-Strukturen".

Gemäß der Erfindung können bei doppelt facettierten Beleuchtungssystemen sämtliche oben beschriebenen Settings gleichzeitig realisiert werden. In einer ersten Ausgestaltung der Erfindung hält man auf dem zweiten optischen Element mit Rasterelementen, die nachfolgend auch als Pupillenwaben bezeichnet werden, sämtliche Ausleuchtungen in der Austrittspupille vor.

Durch Tausch des ersten optischen Elementes oder Linse mit Rasterelementen, die nachfolgend auch als Feldwaben bezeichnet werden, oder durch Ändern des Kipps der Rasterelemente auf der Platte des ersten optischen Elementes können dann gezielt jeweils nur die Pupillenwaben eines bestimmten Settings bsp. des Quadrupol-Settings ausgeleuchtet werden. Die Pupillenwaben sind hierzu an die von der Lichtquelle abhängige Ausleuchtung der Feldwabe angepaßt. Zwischen Feld- und Pupillenwabe findet durch entsprechende Kippwinkel bzw. prismatische Wirkung der Rasterelemente eine Sortierung der Eingangslichtverteilung auf der Feldwabe in die Ausgangslichtverteilung auf der Pupillenwabe und somit in der Eintrittspupille des Lithographieobjektives statt.

In einer alternativen Ausführungsform der Erfindung kann vorgesehen sein, daß nicht alle Settings auf dem zweiten optischen Element vorgehalten werden. Die Ausleuchtung wird dann beispielsweise durch Tausch sowohl des ersten wie des zweiten optischen Elementes eingestellt. Durch den Tausch wird erreicht, daß der Auftreffpunkt der Lichtkanäle in der Austrittspupille, die durch die Zuordnung von Rasterelementen des ersten optischen Elementes zu Rasterelementen des zweiten optischen Elementes bestimmt sind und damit die Lichtverteilung in der Austrittspupille eingestellt wird.

Natürlich kann in einer alternativen Ausführungsform die Ausleuchtung in der Austrittspupille durch Verfahren und/oder Verkippen der Rasterelemente des zweiten optischen Elementes und Verkippen der Rasterelemente des ersten optischen Elementes mit Rasterelenten erzielt werden.

Nachfolgend sollen die bevorzugten Weiterbildungen der Erfindung anhand von Spiegelsystemen beispielhaft beschrieben werden, ohne daß hierin eine Beschränkung auf reflektive Systeme zu sehen ist. Bei reflektiven Systemen sind die ersten und zweiten optischen Elemente mit Rasterelementen facettierte Spiegel. Der Fachmann wird die beispielhaft genannten Maßnahmen ohne erfinderisches Zutun auf refraktive Systeme übertragen, ohne daß dies explizit erwähnt wird.

Bei den erfindungsgemäßen Systemen mit zwei optischen Elementen mit Rasterelementen ist die Form der Pupillenwaben an die Form der sekundären Lichquellen angepaßt und somit verschieden von der Form der ersten Feldwaben. Besonders bevorzugt sind die Pupillenwaben elliptisch oder rund, wenn auch die Lichtquelle rund ausgebildet ist.

In einer bevorzugten Ausführungsform der Erfindung sind die Feld- und Pupillenwaben mit einer prismatischen Wirkung ausgestattet, d.h. sie lenken den Hauptstrahl durch jede einzelne Wabe entsprechend eines vorgegebenen Winkels ab.

Die Feldwaben können zusätzlich entweder eine isotrope optische Wirkung aufweisen und dasselbe Aspektverhältnis wie das auszuleuchtende Feld oder eine anisotrope Wirkung mit einem geringerem Aspektverhältnis wie das auszuleuchtende Feld.

Damit sich die einzelnen Strahlenbüschel der Feldwaben im Feld wieder überlappen, kann in einer vorteilhaften Ausführungsform der Erfindung vorgesehen sein, die Pupillenwaben in bezug auf die Pupillenwabenplatte zu neigen bzw. entsprechend zu verkippen.

Ist das System als System mit reellen Zwischenbildern der Lichtquelle hinter der Feldwabenplatte aufgebaut, so können die Pupillenwaben gleichzeitig als Feldlinsen für die gekoppelte Abbildung der Lichtquelle in die Eintrittspupille des Lithographieobjektives dienen.

Ein Lichtbüschel, welches durch ein Rasterelement des ersten Spiegels, d.h. eine Feldwabe und einem Rasterelement des zweiten Spiegels, d.h eine Pupillenwabe fällt, wird in vorliegender Anmeldung als Kanal bezeichnet. Die Anzahl N der Kanäle wird durch die Anzahl der ausgeleuchteten Feldwaben bestimmt.

Bei der ersten Ausgestaltung der Erfindung ist die Anzahl der Pupillenwaben M der Pupillenwabenplatte stets größer als N, da auf der Pupillenwabenplatte alle einstellbaren Ausleuchtungen in der Austrittspupille vorgehalten werden. Hierzu ist es erforderlich, mehr Pupillenwaben gleichzeitig zu realisieren, als es aus der Anzahl der Kanäle der Feldwabenplatte erforderlich wäre. Das wiederum bedeutet, daß es mehr Pupillenwaben als Kanäle gibt und bei einem Setting mit einer bestimmten Feldwabe mit N Kanälen nur ein Teil der Pupillenwaben ausgeleuchtet werden. Dies führt zu einer segmentierten oder parzellierten Ausleuchtung der Pupille. Notwendige Voraussetzung hierfür ist, daß der Lichtleitwert der Lichtquelle bzw. der Etendue geringer als der des Lithographieobjektives ist, da andernfalls keine segmentierte Ausleuchtung der Austrittspupille vorliegt. Damit wäre es nicht mehr möglich, in der Pupillenebene mehr Waben als Kanäle unterzubringen bzw. es würde über ein Übersprechen über die Kanäle zu Lichtverlust und Streulicht kommen. Gegenwärtig sind die Lichtleitwerte der EUV-Quellen, beispielsweise von Synchotron- oder Plasma-Quellen geringer als der des Lithographieobjektives.

In einer weiteren vorteilhaften Auführungsform wird das zweite optische Element mit Spiegel-Facetten so aus der Ebene sekundären Lichtquellen, welche hinter dem ersten optischen Element mit Spiegel-Facetten entstehen, in oder gegen Lichtrichtung geringfügig verschoben, daß eine gleichmäßige Ausleuchtung auf den Spiegelfacetten des zweiten optischen Elementes und damit eine geringere lokale Wärmebelastung erzielt wird. Der Betrag der Defokussierung wird so festgesetzt, daß die Ausdehnung der sekundären Lichtquellen kleiner ist als die Größe der Pupillenwaben, wobei die Breite des unbeleuchteten Randbereiches kleiner als 10% des minimalen Durchmessers der Pupillenwaben ist. Ein unbeleuchteter Bereich liegt dann vor, wenn die Intensität in diesem Bereich < 10% der maximalen Intensität der sekundären Lichtquelle ist.

In einer bevorzugten Ausführungsform sind den Spiegeln mit Rasterelementen weitere optische Elemente wie Feldspiegel nachgeordnet, die dazu dienen, die Pupillenebene in die Austrittspupille des Beleuchtungssystems, die mit der Eintrittspupille des Projektionsobjektives zusammenfällt, abzubilden und das Ringfeld zu formen.

Besonders bevorzugt ist es, wenn die optischen Elemente grazing-incidence-Spiegel mit Inzidenzwinkel $\leq$ 15° umfassen. Um die mit jeder Reflektion verbundenen Lichtverluste zu minimieren, ist mit Vorteil vorgesehen, wenn die Anzahl der Feldspiegel gering gehalten wird. Besonders bevorzugt sind Ausführungsformen mit höchstens drei Feldspiegeln.

Als Lichtquellen für die EUV-Strahlung sind Laser-Plasma, Plasma oder Pinch-Plasma-Quelle sowie andere EUV-Lichtquellen denkbar.

Andere EUV-Lichtquellen sind beispielsweise Synchrotronstrahlungsquellen. Synchronstrahlung wird emittiert, wenn relativitische Elektronen in einem Magnetfeld abgelenkt werden. Die Synchrotron-Strahlung wird tangential zur Elektronenbahn emittiert.

Nachfolgend soll die Erfindung anhand der Zeichungen beschrieben werden.

Es zeigen:

Figur 1:  Prinzipskizze des Strahlenganges eines Systems mit zwei optischen Elementen mit Rasterelementen

Figuren 2a u. 2b:  Feld- und Pupillenabbildung für das zentrale Wabenpaar

Figur 3:  Prinzipskizze des Strahlenganges eines Systems mit zwei Spiegeln mit Rasterelementen und Kollektoreinheit

Figuren 4a - 4b: Strahlengang in einem refraktiven System mit zwei Linsen mit Rasterelementen mit einer ersten und einer zweiten Anordnung der Rasterelemente auf der ersten Linse, ergebend zwei unterschiedliche Ausleuchtungen

Figuren 5a - 5b: Strahlengang in einem reflektiven System mit zwei Spiegeln mit Rasterelementen mit einer ersten und einer zweiten Anordnung der Rasterelemente auf dem ersten Spiegel

Figur 6a: Draufsicht auf eine Feldwabenplatte mit 72 Feldwaben

Figur 6b.1 Draufsicht auf eine Pupillenwabenplatte gemäß der Erfindung mit 200 Pupillenwaben bei kreisförmiger Ausleuchtung

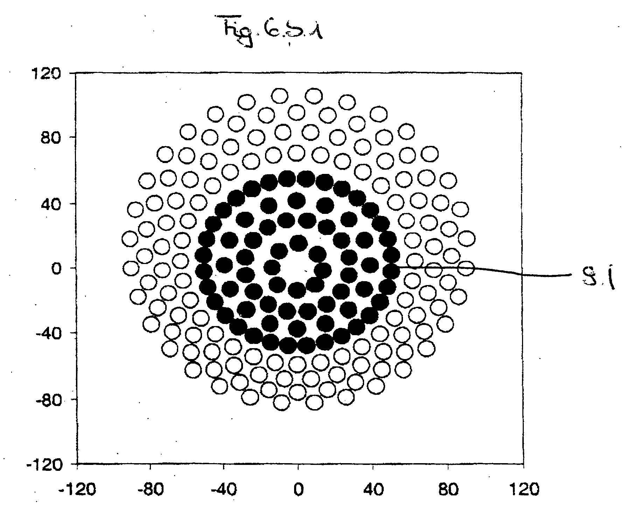

Figur 6b.2 Draufsicht auf eine Pupillenwabenplatte gemäß der Erfindung mit 200 Pupillenwaben bei ringförmiger Ausleuchtung

Figur 6b.3 Draufsicht auf eine Pupillenwabenplatte gemäß der Erfindung mit 200 Pupillenwaben bei quadropolarer Ausleuchtung

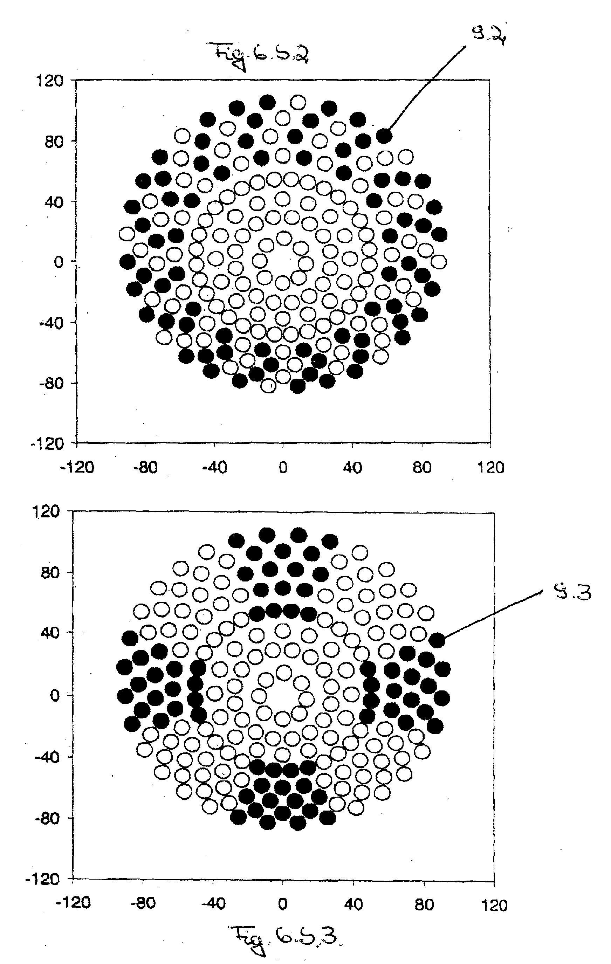

Figur 7: kreisförmige Ausleuchtung der Austrittspupille eines erfindungsgemäßen Systems

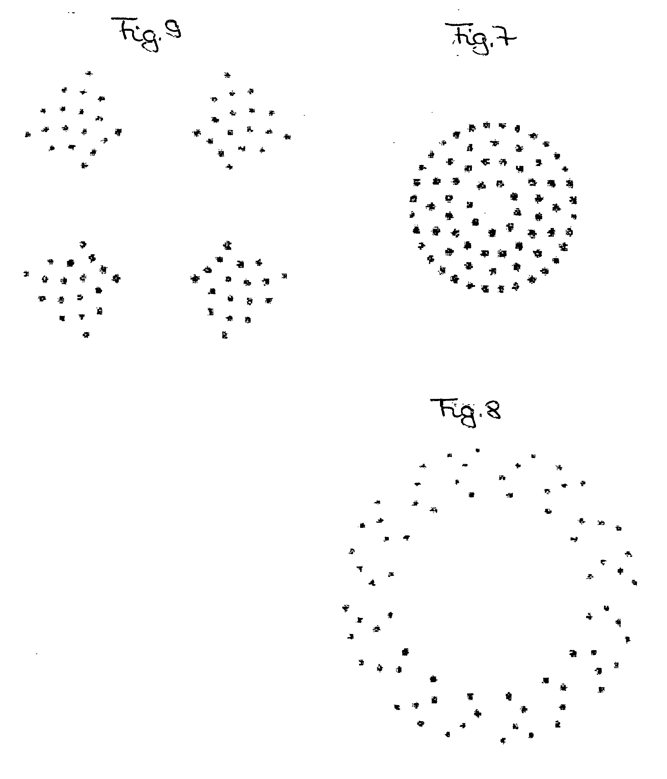

Figur 8: ringförmige Ausleuchtung der Austrittspupille eines erfindungsgemäßen Systems

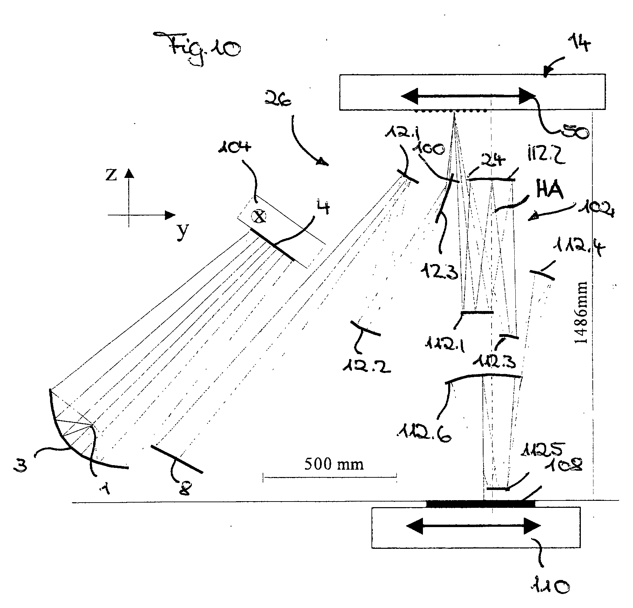

Figur 9: Quadrupol-Ausleuchtung des erfindungsgemäßen Systems

Figur 10: Aufbau eines EUV-Projektionssystems mit einem erfindungsgemäßen Beleuchtungssystem

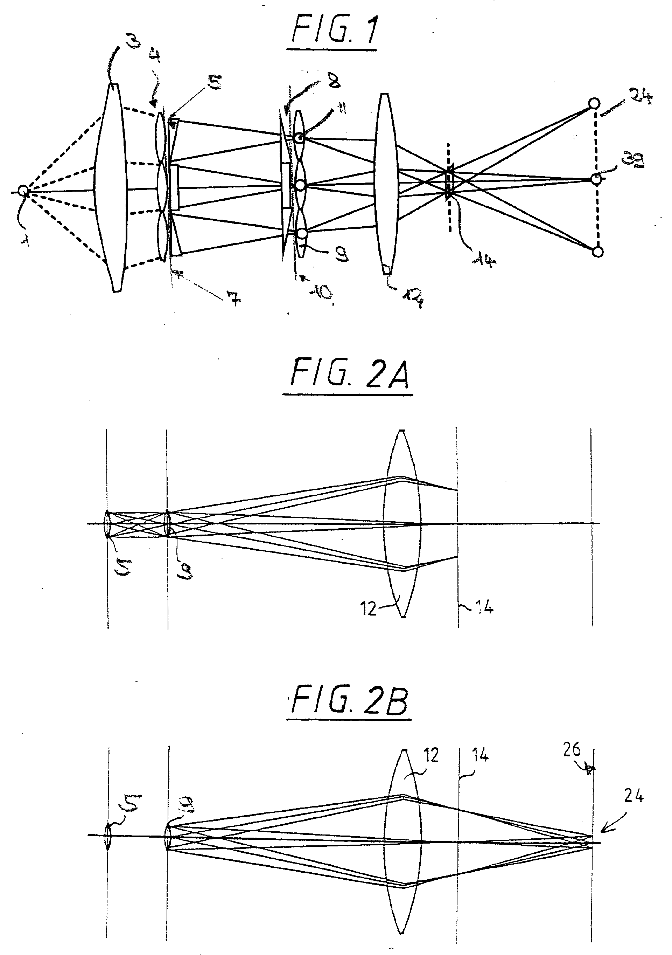

In Figur 1 ist eine Prinzipskizze des Strahlengangs eines Systemes mit zwei facettierten optischen Elementen in refraktiver Darstellung abgebildet. Das Licht der Lichtquelle 1 wird mit Hilfe einer Kollektorlinse 3 gesammelt und in ein paralleles oder konvergentes Lichtbüschel umgewandelt. Die Rasterelemente des ersten optischen Elementes 4, die nachfolgend auch als Feldwaben 5 bezeichnet werden und auf einer ersten Wabenplatte 7 angeordnet sind, zerlegen die Lichtbüschel und erzeugen am Ort der Rasterelemente 9 des zweiten optischen Elementes 8 mit Rasterelementen 9, die auf einer Platte 10 angeordnet sind, sekundäre Lichtquellen 11. Die Rasterelemente 9 des zweiten optischen Elementes 8 werden nachfolgend auch als Pupillenwaben bezeichnet. Die Feldlinse 12 bildet die sekundären Lichtquellen in die Austrittspupille 24' des Beleuchtungssystems bzw. die Eintrittspupille 100 des nicht dargestellten nachfolgenden Objektives ab. Die Eintrittspupille 100 des Objektives fällt mit der Austrittspupille 24 des Beleuchtungssystems zusammen. Eine derartige Anordnung zeichnet sich durch einen verflochtenen Strahlengang von Feld- und Pupillenebene von der Lichtquelle 1 bis zur Eintrittspupille 100 des Objektivs aus. Hierfür wird oft auch die Bezeichnung "Köhlersche Beleuchtung" verwendet wie beispielsweise aus Lexikon der Optik , Leipzig, 1990, S. 183 ersichtlich.

Die Feldwaben 5 wie auch die Pupillenwaben 9 sind in dem dargestellten Ausführungsbeispiel sammelnd ausgebildet und weisen eine prismatische Wirkung auf. Beide Eigenschaften sind in Figur 1 getrennt dargestellt.

Nachfolgend wird das Beleuchtungssystem gemäß Fig. 1 abschnittsweise betrachtet. Da die Schnittstelle die Licht- und Aperturverteilung in der Ebene der Feldwaben ist, kann die Betrachtung unabhängig von der Quellenart und dem Kollektorspiegel erfolgen.

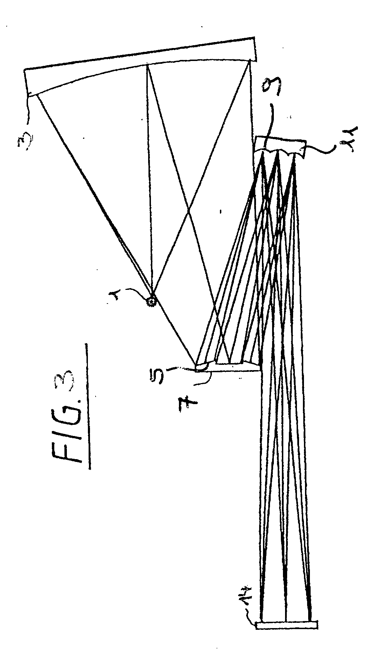

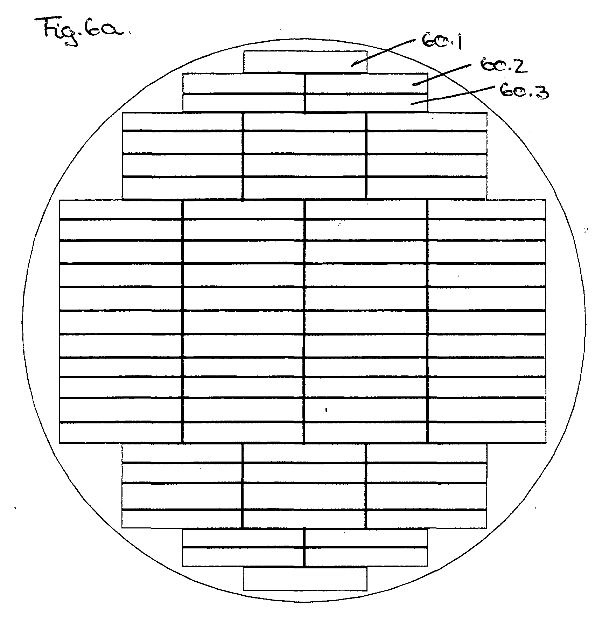

In den Figuren 2A und 2B ist für das zentrale Wabenpaar 5, 9 die Feld- und Pupillen-Abbildung eingezeichnet. Mit Hilfe der Pupillenwabe 9 und der Feldlinse 12 wird die Feldwabe 5 auf das Retikel 14 bzw. die abzubildende Maske abgebildet. Die geometrische Ausdehnung der Feldwabe 5 bestimmt die Form des ausgeleuchteten Feldes in der Retikelebene 14. Liegen Feldwaben 5 mit isotroper optischer Wirkung vor und wird die Form der Feldwaben 5 rechteckig gewählt, so entspricht das Aspektverhältnis der Feldwaben 5 dem Verhältnis von Bogenlänge zu Ringbreite des geforderten Ringfeldes in der Objekt- bzw. Retikelebene 14. Das Ringfeld wird, wie in den Fig.5a-5b dargestellt, durch die Feldlinse geformt. Ohne Feldlinse ergibt sich, wie in Fig. 3 gezeigt, in der Retikelebene 14 ein Rechteckfeld.

Der Abbildungsmaßstab ist näherungsweise durch das Verhältnis der Abstände Pupillenwabe 9 - Retikelebene 14 und Feldwabe 5 - Pupillenwabe 9 gegeben. Die optische Wirkung der Feldwabe 5 ist so ausgelegt, daß am Ort der Pupillenwabe 9 ein Bild der Lichtquelle 1 entsteht, die nachfolgend auch als sekundäre Lichtquellen 11 bezeichnet werden.

Wie in Figur 2 B gezeigt, besteht die Aufgabe der Feldlinse 12 darin, die sekundären Lichtquellen 11 in die Austrittspupille 24 des Beleuchtungssystems 26, die vorliegend mit der Eintrittspupille des Objektivs zusammenfällt, abzubilden. Bringt man in den Strahlengang eine Feldlinse 12 ein, so wird die Feldabbildung in der Weise beeinflußt, daß sie das Ringfeld durch Steuerung der Verzeichnung formt. Der Abbildungsmaßstab der Feldwabenabbildung wird dadurch nicht verändert.

Bei einem Beleuchtungssystem im EUV-Wellenlängenbereich müssen alle Komponenten reflektiv ausgebildet werden.

Wegen der hohen Reflektionsverluste bei λ = 10 nm - 14 nm ist es vorteilhaft, daß die Zahl der Reflektionen so gering wie möglich gehalten werden.

Beim Aufbau des reflektiven Systems muß die gegenseitige Vignettierung der Strahlen berücksichtigt werden. Dies kann durch Aufbau des Systemes im Zick-Zack-Strahlengang erfolgen oder durch Arbeiten mit Obskurationen.

Zur Formung des Ringfeldes in der Retikelebene 14 kann bei reflektiven Systemen ein grazing-incidence-Feldspiegel verwandt werden.

In Figur 3 ist eine Ausführungsform der Erfindung, bei der als Lichtquelle 1 eine Plasma-Lichtquelle verwendet wird, dargestellt. Das System ist rein reflektiv aufgebaut und ohne Feldspiegel gezeigt.

Das Beleuchtungssystem umfaßt im vorliegenden Ausführungsbeispiel als Lichtquelle eine Pinch-Plasma-Quelle 1, als EUV-Kollektor einen Kollektorspiegel 3, der das Licht sammelt und in die Feldwabenplatte 7 reflektiert, eine Pupillenwabenplatte 11 sowie ein Retikel in einer Retikelebene 14. Durch Reflexion an den Feldwaben 5 wird das Licht zu den jeweiligen Pupillenwaben 9 der Pupillenwabenplatte 11 geführt und von dort in die Retikelebene 14. Die Pinch-Plasma-Quelle ist eine ausgedehnte Lichtquelle (ca. 1 mm) mit einer gerichteten Strahlung in einen relativ kleinen Raumwinkelbereich von ungefähr Q = 0,3 sr. Die Austrittspupille des Beleuchtungssystems ist in Figur 3 nicht dargestellt.

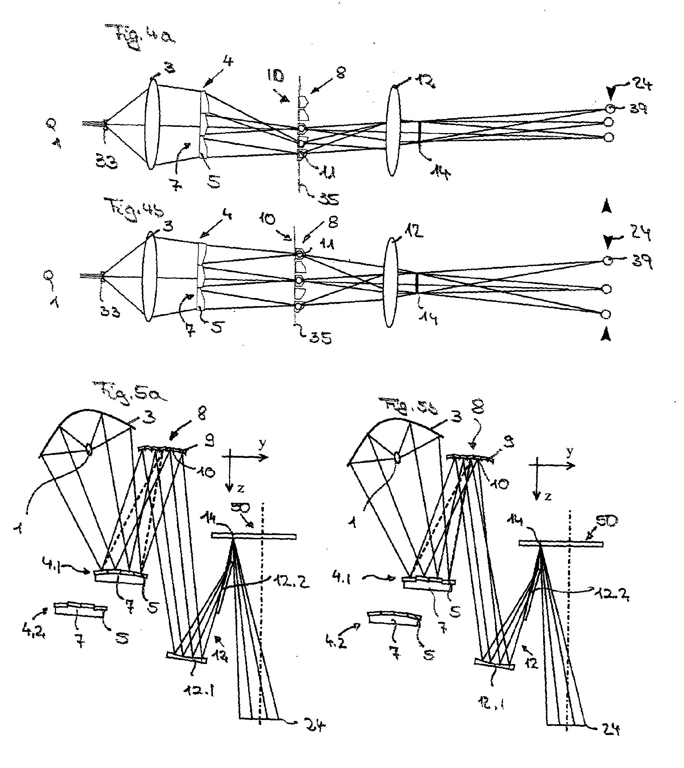

In den Figuren 4a und 4b ist ein erfindungsgemäßes System in refraktiver Darstellung gezeigt.

Gleiche Bauteile wie in den vorangegangenen Figuren werden mit denselben Bezugsziffern belegt. Als Lichtquelle dient vorliegend ohne Beschränkung hierauf eine stark gerichtete Lichtquelle. Eine solche Lichtquelle ist im EUV-Bereich eine Synchrotron-Lichtquelle. Um die stark gerichtete Strahlung mit einer Divergenz beispielsweise weniger als 10 mrad aufzuweiten, weist das System ein Zerstreuelementes 33 auf.

Betreffend die Ausgestaltung von doppelt facettierten Beleuchtungssystemen mit einer Synchrotron-Strahlungsquelle wird auf die WO 99/57732 verwiesen, deren Offenbarungsgehalt in die vorliegende Anmeldung vollumfänglich mit aufgenommen wird. Bei anderen Lichtquellen, wie beispielsweise Laserplasmaquellen, kann eine derartige Strahlaufweitung entfallen.

Der von der Lichtquelle ausgehende Strahl wird durch die Kollektorlinse 3 auf das erste Linsearray 4 mit Rasterelementen gelenkt. In der dargestellten refraktiven Ausführungsform umfaßt das erste Linsearray 4 mit Rasterelementen eine Wabenplatte 7, auf der eine Vielzahl von Feldwaben 5 angeordnet ist. Die einzelnen Feldwaben 5 weisen eine prismatische Wirkung auf und bilden somit in der Ebene 35 eine Vielzahl von sekundären Lichtquellen 11. In der Ebene 35 ist ein zweites Linsenarray 8 mit Rasterelementen angeordnet. Auch dieses zweite Linsenarray 8 umfaßt eine Wabenplatte 10. Die auf der zweiten Wabenplatte angeordneten Rasterelemente sind Pupillenwaben 9. Die prismatische Wirkung der Rasterelemente 5 des ersten Linsenarrays 4 ist so gewählt, daß die sekundären Lichtquellen 11 mit jeweils einer bestimmten Pupillenwabe 9 auf dem zweiten Linsenarray 8 mit Rasterelementen zusammenfällt. Durch eine derartige Anordnung ist jeder Feldwabe 5 eine Pupillenwabe 9 des jeweiligen Settings zugeordnet. Ein Lichtbüschel, welches durch eine Feldwabe 5 und eine bestimmte Pupillenwabe 9 fällt, wird in der vorliegenden Anmeldung als Kanal bezeichnet. Die Anzahl der möglichen Kanäle N wird durch die Anzahl der ausgeleuchteten Feldwaben 5 auf der Feldwabenplatte 7 vorgegeben. Da in der dargestellten Ausführungsform in der Pupillenwabenplatte 10 alle einstellbaren Ausleuchtungen in der Austrittspupille 24 vorgehalten werden, ist die Anzahl der Pupillenwaben 9 auf der Pupillenwabenplatte 10 stets größer als die Anzahl der Kanäle. Die Beleuchtung nur bestimmter Pupillenwaben 9 auf der Pupillenwabenplatte 10 führt zu einer segmentierten bzw. parzellierten Ausleuchtung in der Austrittspupille 24.

Das Licht, das die ausgewählten Pupillenwaben 9 durchläuft, wird mit Hilfe der Feldlinse 12 geformt, die sich nahe der Objekt- bzw. Retikelebene 14 befindet. In der Retikelebene 14 überlagern sich die Bilder der Feldwaben 5. Die Bilder 39 der sekundären Lichtquellen 11 füllen die Austrittspupille 24 des Beleuchtungssystems, die mit der Eintrittspupille des nicht dargestellten Objektives zusammenfällt, in segmentierter Art und Weise.

Die Segmentierung der Bilder der sekundären Lichtquellen 39 in der Austrittspupille 24 ist ein direktes Spiegelbild der ausgeleuchteten Pupillenwaben 9 in der Ebene 35 und damit der Selektion derselben durch die Feldwaben 5.

Wird nun die Feldwabenplatte 7 aus Figur 4a gegen die in Figur 4b dargestellte Feldwabenplatte getauscht, auf der Feldwaben mit anderer prismatischer Wirkung wie die Feldwaben auf der Feldwabenplatte 7 gemäß Figur 4a angeordnet sind, so werden andere Pupillenwaben 9 auf der Pupillenwabenplatte 10 ausgeleuchtet. Die Bilder der sekundären Lichtquellen 39 haben demzufolge eine andere Lage in der Austrittspupille 24 wie die Bilder der sekundären Lichtquellen gemäß Figur 4a.

In den Figuren 5a und 5b sind reflektive Ausführungen der Erfindung dargestellt. Von der Wirkung der gleichen Bauteile wie in der in den Figuren 4a bis 4b dargestellten refraktiven Ausführungsform sind mit denselben Bezugsziffern belegt. Anstelle eines Linsenarrays für die ersten und zweiten optischen Elemente 4,8 mit Rasterelementen sind dies im reflektiven Ausführungsbeispiel Spiegel mit Rasterelementen 5,9. Die Rasterelemente bzw. Facetten 5,9 sind auf Wabenplatten 7,10 unter einem bestimmten Kippwinkel angeordnet. Ändert man die Kippwinkel der einzelnen Feldwaben 5 auf der Feldwabenplatte 7 und damit die prismatische Wirkung der Feldwaben 5 , so kann die Zuordnung der Feldwaben 5 zu den Pupillenwaben 9 auf der Pupillenwabenplatte und damit analog zum in Fig. 4a und 4b dargestellten refraktiven Stystem die Ausleuchtung in der Austrittspupille 24 geändert werden.

Die beispielhaft gezeigten ersten Spiegel mit Rasterelementen mit unterschiedlich gekippten Feldwaben 5 auf der Wabenplatte 7 sind mit 4.1 und 4.2 bezeichnet. Eine Änderung des Kippwinkels der Feldwaben könnte durch Aktuatoren direkt auf der Feldwabenplatte bewirkt werden oder durch Tausch des Spiegels 4.1 gegen den Spiegel 4.2, die sich durch die unter unterschiedlichem Kippwinkel auf der Feldwabenplatte des Spiegels angeordneten Feldwaben unterscheiden. Anstatt einer Feldlinse wird im reflektiven System als feldabbildende und feldformende Gruppe ein normal incidence Feldspiegel 12.1 und ein grazing incidence Feldspiegel 12.2 eingesetzt.

In einem Scanning EUV-System ist das Retikel auf einem Retikelträger 50 in der y-Richtung verfahrbar angeordnet.

Die Figuren 4a bis 4b und 5a bis 5b verdeutlichen, daß durch einfachen Tausch der Feldwabenplatte 7 und Selektion der ausgeleuchteten Pupillenwaben 9 auf der Pupillenwabenplatte 10 die Ausleuchtung in der Austrittspupille 24 des Beleuchtungssystems beeinflußt werden kann.

Bei reflektiven Systemen können die Feldwaben 5 Spiegelelemente mit sammelnder Wirkung sein. Alternativ hierzu kann die sammelnde Wirkung vollständig auf den Kollektorspiegel übertragen werden und die Feldwaben als Planfacetten ausgebildet sein.

Weisen die Feldwaben der Feldwabenplatten unterschiedlicher Spiegel mit Rasterelementen unterschiedliche prismatische Wirkung auf, so können wie in den Figuren 5a-5b dargestellt, durch Austausch eines Spiegels mit Rasterelementen gegen eine anderen Spiegel mit Rasterelementen unterschiedliche Ausleuchtungen in der Austrittspupille 24 realisiert werden. Alternativ hierzu kann die prismatische Wirkung einzelner Feldwaben eines Spiegels durch Ändern des Kippwinkels bspw. mit Aktuatoren der jeweiligen Feldwaben auf der Feldwabenplatte des Spiegels mit Rasterelementen erreicht werden.

Um Lichtstrahlen in der Feldebene, die mit der Retikelebene 14 zusammenfällt, zu überlagern, weisen die Pupillenwaben ebenfalls eine prismatische Wirkung auf bzw. bei reflektiven Systemen wird der Neigungswinkel der Pupillenwaben auf der Pupillenwabenplatte 11 dementsprechend eingestellt.

Die Feldwaben 5 können entweder von isotropischer optischer Wirkung sein und weisen dann dasselbe Aspektverhältnis wie das in der Feldebene 14 auszuleuchtende Feld auf oder aber sie sind von anisotroper Wirkung. Dann ist das Aspektverhältnis der Feldwaben verschieden vom Aspektverhältnis des Feldes, in der Regel ist das Aspektverhältnis der Feldwaben geringer wie das Aspektverhältnis des Feldes.

Figur 6a zeigt eine Draufsicht auf ein Beispiel einer Feldwabenplatte 7 mit insgesamt 72 Rasterelementen, die in Zeilen 60.1, 60.2... und zueinander verschoben angeordnet sind.

Die Figur 6b.1 - 6b.3 zeigen eine Draufsicht auf eine Pupillenwabenplatte, wobei für jedes der unterschiedlichen Ausleuchtungssettings, nämlich kreisförmiges Setting, ringförmiges bzw. annulares Setting und Quadrupol-Setting die 72 Kanäle der Feldwabenplatte zur Verfügung stehen. Für eine konventionelle Beleuchtung müssen alle 72 Kanäle gleichmäßig über alle Feldwaben verteilt werden. Idealerweise sind die Pupillenwaben alle gleich groß oder zumindest so groß, daß sie jeweils von einem Bild der sekundären Lichtquellen nicht vollständig ausgeleuchtet werden.

In Figur 6b.1 sind die beim kreisförmigen Setting ausgeleuchteten Pupillenwaben 9.1, die dunkel dargestellt sind, gezeigt. In Figur 6b.2 sind die bei annularem Setting ausgeleuchteten Pupillenwaben 9.2 dunkel dargestellt und in Figur 6b.3 sind die beim Quadrupol-Setting ausgeleuchteten Pupillenwaben mit den Ziffern 9.3 gezeigt.

In den Figuren 7 bis 9 ist die Verteilung der Bilder der sekundären Lichtquellen 39 für die unterschiedliche Ausleuchtung in der Austrittspupille schematisch gezeigt.

Figur 7 zeigt ein kreisförmiges Setting mit σ = 0,4 bei kreisförmiger Ausleuchtung der Pupillenwabenplatten.

Figur 8 stellt ein annulares Setting mit

$$\frac{\sigma_{out}}{\sigma_{in}} = \frac{0,8}{0,4}$$

bei ringförmiger Ausleuchtung der Pupillen dar.

Figur 9 zeigt ein Quadrupolsetting mit vier Ring-Kreissegmenten als Ausleuchtung.

Die unterschiedlichen Settings der Beleuchtungsverteilung in der Austrittspupille können erfindungsgemäß durch Tausch der Feldwabenplatte oder Verändern des Neigungswinkels der einzelnen Feldwaben auf der Feldwabenplatte erreicht werden.

In Figur 10 ist ein komplettes EUV-Beleuchtungssystem gezeigt, in dem ein erfindungsgemäßes System zur Einstellung der Ausleuchtung in der Austrittspupille 24 des Beleuchtungssystems 26, die mit der Eintrittspupille 100 des Objektivs 102 zusammenfällt, dargestellt ist. Das System umfaßt eine Lichtquelle 1, einen Kollektorspiegel 3 zum Sammeln des Lichtes der Lichtquelle 1, einem ersten optischen Element 4 mit Rasterelementen 5, einem zweiten optischen Element 8 mit Rasterelementen 9 sowie drei feldformenden Spiegeln 12.1, 12.2, 12.3, die dem zweiten optischen Element 8 mit Rasterelementen 9 nachgeordnet sind und im wesentlichen dazu dienen, das Feld in der Retikelebene 14 zu formen. Das Retikel in der Retikelebene 14 ist vorliegend eine Reflektionsmaske. Das Retikel ist in dem als Scanning-System ausgelegten EUV-System in y-Richtung verfahrbar.

Um unterschiedliche erste optische Elemente zur Setting-Einstellung in den Strahlengang des Beleuchtungssystems zu verbringen, sind mehrere Feldwabenplatten 7 mit unterschiedlicher prismatischer Wirkung auf einem weiteren Trägersystem 104 angeordnet. Das weitere Trägersystem 104 ist einer Ebene parallel zur Retikelebene senkrecht zur y-Richtung, das heißt im vorliegenden Beispiel in x-Richtung verfahrbar. Hierdurch können unterschiedliche Feldwabenplatten in den Strahlengang verbracht werden und so unterschiedliche Lichtkanäle zwischen dem ersten optischen Element mit Rasterelementen und dem zweiten optischen Element mit Rasterelementen und damit Ausleuchtungen der Austrittspupille des Beleuchtungssystems, die mit der Eintrittspupille 100 des nachfolgenden Objektives 102 zusammenfällt, realisiert werden.

Das nachfolgende Projektionsobjektiv ist ein 6-Spiegel-Projektionsobjektiv, 106 wie beispielsweise in der US-Patentanmeldung 09/503,640 gezeigt, deren Offenbarungsgehalt in vorliegende Anmeldung vollumfänglich mit aufgenommen wird. Das zu belichtende Objekt 108 befindet sich ebenfalls auf einem Trägersystem 110, das verfahren werden kann. Die Spiegel 112,1, 112.2, 112.3, 112,4, 112.5, 112.6 des Projektionsobjektives sind zentriert zur gemeinsamen optischen Achse HA. Das ringförmige Objektfeld in der Retikelebene 14 ist außeraxial angeordnet. Der Lichtstrahl zwischen Retikel und dem ersten Spiegel des Projektionsobjektives ist zur optischen Achse des Projektionsobjektives konvergent. Die Hauptstrahlwinkel mit Bezug auf die Normale des Retikels liegen vorzugsweise zwischen 5° und 7°.

Wie aus Figur 10 hervorgeht, ist das Beleuchtungssystem deutlich vom Projektionsobjektiv separiert.

Mit der Erfindung wird erstmals eine einfach aufgebaute Vorrichtung angegeben, mit der unterschiedliche Settings in der Austrittspupille eines Beleuchtungssystems realisiert werden können.


Bezugszeichenliste

| | |
|---|---|
| 1: | Lichtquelle |
| 3: | Kollektorlinse |
| 4: | erstes optisches Element |
| 4.1.: | erster Spiegel mit Rasterelementen in einer ersten Anordnung |
| 4.2: | erster Spiegel mit Rasterelementen in einer zweiten Anordnung |
| 5: | Feldwaben |
| 7: | erste Wabenplatte |
| 8: | zweites optisches Element |
| 9: | Pupillenwaben |
| 10: | zweite Wabenplatte |
| 11: | sekundäre Lichtquellen |
| 12: | Feldlinse |
| 12.1: | normal incidence Feldspiegel |
| 12.2: | grazing incidence Feldspiegel |
| 12.3: | normal incidence Feldspiegel |
| 14: | Retikelebene |
| 24: | Austrittspupille des Beleuchtungssystems |
| 26: | Beleuchtungssystem |
| 33: | Zerstreuelement |
| 35: | Ebene der sekundären Lichtquellen 11 |
| 39: | Bilder der sekundären Lichtquellen |
| 50: | Retikelträger |
| 60.1, 60.2..: | Zeilen der Feldwabenplatte |
| 100: | Eintrittspupille des Objektives |
| 102: | Projektionsobjektiv |
| 104: | weiteres Trägersystem |
| 106: | 6-Spiegel Projektionsobjektiv |
| 108: | zu belichtendes Objekt |
| 110: | Trägersystem für das Objekt |
| 112.1, 112.2, 112.3, 112.4, 112.5, 112.6: | Spiegel des Projetionsobjektives |
| HA: | optische Achse des Projektionsobjektives |
| x-Richtung: | Verschieberichtung des Trägersystems der unterschiedlichen Feldwabenplatten |
| y-Richtung: | Scanrichtung des Retikels |

**EP 1 202 101 A2**

**Patentansprüche**

1. Beleuchtungssystem für Wellenlängen ≤ 193 nm, insbesondere für die EUV-Lithographie, mit

   1.1 einer Lichtquelle (1)
   1.2 einer Objektebene (14)
   1.3 einer Austrittspupille (24)
   1.4 einem ersten optischen Element mit Rasterelementen (5), das durch die Lichtquelle (1) ausgeleuchtet wird und daß das von der Lichtquelle (1) her einfallende Lichtbündel in Lichtkanäle zerlegt
   1.5 einem zweiten optischen Element mit Rasterelementen (9), wobei jedem Lichtkanal, der von dem Rasterelement (5) des ersten optischen Elementes ausgebildet wird, ein Rasterelement (9) des zweiten optischen Elementes zugeordnet ist,
   wobei
   1.6 die Rasterelemente (5, 9) des ersten optischen Elementes und des zweiten optischen Elementes jeweils Lichtkanälen zugeordnet sind, und die Rasterelemente (6, 9) derart ausgestaltet oder angeordnet werden, daß sich für jeden Lichtkanal ein durchgehender Strahlverlauf von der Lichtquelle (1) bis zur Objektebene (14) ergibt **dadurch gekennzeichnet, daß**
   1.7 die Zuordnung derart manipulierbar ist, daß durch die Zuordnung der Rasterelemente des ersten und des zweiten optischen Elementes eine vorgegebene Ausleuchtung in der Austrittspupille des Beleuchtungssystems eingestellt wird.

2. Beleuchtungssystem nach Anspruch 1, **dadurch gekennzeichnet, daß** das zweite optische Element eine derartige Anzahl an Rasterelementen umfaßt, daß mindestens zwei vorgegebene Ausleuchtungen durch Änderung der Zuordnung der Rasterelemente des ersten optischen Elementes zu den Rasterelementen des zweiten optischen Elementes eingestellt werden können, ohne daß das zweite optische Element getauscht werden muß.

3. Beleuchtungsssystem nach Anspruch 2, **dadurch gekennzeichnet, daß**
   das erste optische Element mit Rasterelementen austauschbar ist und durch Tausch des ersten optischen Elementes eine andere Zuordnung der Rasterelemente des ersten optischen Elementes zu den Rasterelementen des zweiten optischen Elementes und damit eine andere Ausleuchtung in der Austrittspupille realisiert wird.

4. Beleuchtungsssystem nach Anspruch 3, **dadurch gekennzeichnet, daß**
   das Beleuchtungssystem eine Verschiebeeinrichtung mit einem Verschiebetisch umfaßt, auf dem eine Vielzahl von ersten optischen Elementen angeordnet ist, so daß durch Verschieben des Verschiebetisches die ersten optischen Elemente austauschbar sind.

5. Beleuchtungssystem nach einem der Ansprüche 1 bis 4, **dadurch gekennzeichnet, daß**
   die Anzahl M der Rasterelemente (9) des zweiten optischen Elementes größer ist als die Anzahl N der Rasterelemente (5) des ersten optischen Elementes.

6. Beleuchtungssystem nach Anspruch 2, **dadurch gekennzeichnet, daß**
   die Rasterelemente (5, 9) des ersten optischen Elementes Spiegel-Facetten sind, die auf einer Platte (7) angeordnet sind und der Lichtkanal zwischen den Rasterelementen des ersten und des zweiten optischen Elementes durch Verkippen der Spiegel-Facetten des ersten optischen Elementes in bezug auf die Plattenebene einstellbar ist, um so unterschiedliche Zuordnungen der Rasterelemente des ersten optischen Elementes zu den Rasterelementen des zweiten optischen Elementes und damit unterschiedliche Ausleuchtungen der Austrittspupille zu realisieren.

7. Beleuchtungssystem nach Anspruch 1, **dadurch gekennzeichnet, daß**
   das zweite optische Element mit Rasterelementen austauschbar ist und mit jedem zweiten optischen Element mindestens eine bestimmte Ausleuchtung in der Austrittspupille realisiert wird, so daß durch Tausch des zweiten optischen Elementes eine andere Zuordnung der Rasterelemente eines ersten optischen Elementes zu den Rasterelementen des zweiten optischen Elementes realisiert wird.

8. Beleuchtungssystem nach Anspruch 7, **dadurch gekennzeichnet, daß**
   das erste optische Element mit Rasterelementen austauschbar ist.

9. Beleuchtungssystem nach Anspruch 7,
**dadurch gekennzeichnet, daß** die Rasterelemente des ersten optischen Elementes Spiegelfacetten sind und der Kipp der Spiegelfacetten des ersten optischen Elementes veränderbar ist.

10. Beleuchtungssystem nach Anspruch 1,
**dadurch gekennzeichnet, daß**
die Rasterelemente des zweiten optischen Elementes Spiegelfacetten sind und die Spiegelfacetten verschiebbar und kippbar sind, um durch Verschieben und Kippen der Spiegelfacetten eine andere Zuordnung der Rasterelemente eines ersten optischen Elementes zu den Rasterelementen des zweiten optischen Elementes realisiert wird.

11. Beleuchtungssystem nach Anspruch 10,
**dadurch gekennzeichnet, daß**
das erste optische Element mit Rasterelementen austauschbar ist.

12. Beleuchtungssystem nach Anspruch 10,
**dadurch gekennzeichnet, daß** die Rasterelemente des ersten optischen Elementes Spiegelfacetten sind und daß der Kipp der Spiegelfacetten des ersten optischen Elementes veränderbar ist.

13. Beleuchtungssystem nach einem der Ansprüche 1 bis 12,
**dadurch gekennzeichnet, daß** die Rasterelemente des ersten optischen Elementes in die Objektebene abgebildet werden und die Lichtkanäle sich in der Objektebene (14) überlagern.

14. Beleuchtungssystem nach einem der Ansprüche 1 bis 13, **dadurch gekennzeichnet, daß**
die Rasterelemente (5) des ersten optischen Elementes in oder in der Nähe der Rasterelemente des zweiten optischen Elementes sekundäre Lichtquellen erzeugen.

15. Beleuchtungssystem nach einem der Ansprüche 1 bis 14, **dadurch gekennzeichnet, daß**
das Beleuchtungssystem eine Kollektoreinheit vor dem ersten Spiegel mit Rasterelementen umfaßt.

16. Beleuchtungssystem nach einem der Ansprüch 1 bis 15,
**dadurch gekennzeichnet, daß**
das System wenigstens einen Spiegel oder eine Linse (12), der dem zweiten optischen Element mit Rasterelementen nachgeordnet ist, umfaßt, wobei der wenigstens eine Spiegel oder Linse eine Ebene, die in oder in der Nähe des zweiten optischen Elementes angeordnet ist, in die Austrittspupille abbildet.

17. Belechtungssystem nach einem der Ansprüche 1 bis 16
**dadurch gekennzeichnet, daß**
die Rasterelemente des zweiten optischen Elementes und wenigstens ein Spiegel oder eine Linse, der dem zweiten optischen Element mit Rasterelementen nachgeordnet ist, die ersten Rasterelemente in die Objektebene abbilden.

18. Beleuchtungssystem nach einem der Ansprüche 1 bis 17, **dadurch gekennzeichnet, daß**
die Lichtkanäle zwischen dem ersten optischen Element mit Rasterelementen und dem zweiten optischen Element mit Rasterelementen derart ausgebildet werden, daß die Ausleuchtung in der Austrittspupille kreisförmig ist.

19. Beleuchtungssystem nach einem der Ansprüche 1 bis 17, **dadurch gekennzeichnet, daß**
die Lichtkanäle zwischen dem ersten optischen Element mit Rasterelementen und dem zweiten optischen Element mit Rasterelementen derart ausgebildet werden, daß die Ausleuchtung in der Austrittspupille ringförmig ist.

20. Beleuchtungssystem nach einem der Ansprüche 1 bis 17, **dadurch gekennzeichnet, daß**
die Lichtkanäle zwischen dem ersten optischen Element mit Rasterelementen und dem zweiten optischen Element mit Rasterelementen derart ausgebildet werden, daß in der Austrittspupille eine Anzahl von Segmenten, die deutlich voneinander getrennt sind, ausgeleuchtet werden.

21. Beleuchtungssystem nach Anspruch 20,
**dadurch gekennzeichnet, daß**
die Anzahl der Segmente eine gerade Anzahl von Segmenten, insbesondere zwei oder vier Segmente ist.

**22.** Verfahren zur Einstellung einer Beleuchtungsverteilung in der Austrittspupille eines Beleuchtungssystems für Wellenlängen $\leq$ 193 nm, insbesondere für die EUV-Lithographie mit einem Beleuchtungssystem gemäß einem der Ansprüche 1 bis 21, **dadurch gekennzeichnet, daß**
eine vorgegebene Lichtverteilung in der Austrittspupille durch Tausch des ersten und/oder zweiten Elementes mit Rasterelementen und/oder durch Ändern der prismatischen Wirkung und der Anordnung der Rasterelemente des ersten und/oder zweiten optischen Elementes, insbesondere Verkippen und/oder Verschieben der Rasterelemente des ersten und/oder zweiten optischen Elementes eingestellt wird, wobei je nach der vorgegebenen Lichtverteilung in der Austrittspupille die Lichtkanäle zwischen den Rasterelementen des ersten und des zweiten optischen Elementes eingestellt werden.

**23.** EUV-Projektionsbelichtungsanlage für die Mikrolithographie mit

- einer Quelle zur Erzeugung von EUV-Strahlung
- einem Beleuchtungssystem gemäß einem der Ansprüche 1 - 21 mit einer Austrittspupille, welches die von der Quelle erzeugte Strahlung teilweise sammelt und zur Beleuchtung eines Ringfeldes weiterleitet
- einer strukturtragenden Maske auf einem Trägersystem, wobei diese Maske in der Ebene des Ringfeldes liegt
- einer Projektionseinrichtung, insbesondere einem Projektionsobjektiv mit einer Eintrittspupille, die mit der Austrittspupille des Beleuchtungssystems zusammenfällt, wobei dieses Projektionsobjektiv den beleuchteten Teil der strukturtragenden Maske in ein Bildfeld abbildet
- ein lichtsensitives Substrat auf einem Trägersystem, wobei dieses lichtsensitive Substrat in der Ebene des Bildfeldes der Projektionseinrichtung liegt.

**24.** EUV-Projektionsbelichtungsanlage gemäß Anspruch 23, **dadurch gekennzeichnet, daß**
die Projektionsbelichtungsanlage ein Scanning-System ist, wobei das Trägersystem für die strukturtragende Maske in der Ringfeldebene in einer ersten Richtung verfahrbar ist.

**25.** EUV-Projektionsbelichtungsanlage gemäß Anspruch 24, **dadurch gekennzeichnet, daß**
die Projektionsbelichtungsanlage ein oder mehrere weitere Trägersysteme zur Aufnahme von mehreren ersten und/oder zweiten optischen Elementen umfaßt, die in einer zweiten Richtung verfahrbar sind und daß die erste Richtung senkrecht auf der zweiten Richtung steht.

**26.** Verfahren zur Herstellung von mikroelektronischen Bauelementen, insbesondere Halbleiterchips mit einer EUV-Projektionsbelichtungsanlage gemäß einem der Ansprüche 24 bis 25.

_FIG.1_

_FIG.2A_

_FIG.2B_

FIG.3

EP 1 202 101 A2

Fig. 4a

Fig. 4b

Fig. 5a

Fig. 5b

Fig. 6a

60.1
60.2
60.3

Fig. 6.5.1

Fig. 6.52

9.2

Fig. 6.53

9.3

EP 1 202 101 A2

Fig. 9

Fig. 7

Fig. 8

18

Fig. 10